# EUROPEAN PATENT SPECIFICATION

(11) **EP 2 227 069 B1**
(45) Date of publication and mention of the grant of the patent: **02.10.2019**
(21) Application number: 08854147.9
(22) Date of filing: 17.10.2008
(51) Int. Cl.: H05B 33/12, H01L 51/50, H05B 33/26, H01L 27/32, H01L 51/52, H01L 27/12

(54) **ORGANIC EL PANEL**
ORGANISCHE EL-TAFEL
PANNEAU ORGANIQUE EL

(30) Priority: 29.11.2007 JP 2007309377
(43) Date of publication of application: 08.09.2010
(73) Proprietor: Nippon Seiki Co., Ltd., Nagaoka-shi, Niigata 940-8580 (JP)
(72) Inventor: CHOU, Raiei, Nagata Niigata (JP); KATAGIRI, Tetsuya, Nagata Niigata (JP)
(74) Representative: Carpmaels & Ransford LLP
(86) International application number: PCT/JP2008/068817
(87) International publication number: WO 2009/069397

(56) References cited:
- EP-A2- 0 158 366
- EP-A2- 1 168 448
- EP-A2- 1 286 397
- WO-A2-03/007378
- JP-A- 2002 090 765
- JP-A- 2003 077 684
- JP-A- 2003 077 685
- JP-A- 2003 197 380
- JP-A- 2007 115 529
- JP-A- 2007 115 529
- US-A1- 2002 033 925
- US-A1- 2004 004 214

## Description

### Technical Field

The present invention relates to an organic EL panel using organic EL (electro luminescent) elements, and in particular, relates to a passive drive organic EL panel.

### Background Art

As an organic EL element, which is a self light emitting element formed of an organic material, one is known which is formed, for example, by sequentially stacking an anode made of ITO (indium tin oxide) or the like, organic layers having at least a light emitting layer, and a non-translucent cathode made of aluminum (Al) or the like (for example, Patent Document 1).

Also, a passive drive method is known as a drive method of an organic EL panel configured of an organic EL element provided on a translucent substrate. The passive drive organic EL panel is such that a signal electrode is formed in a plurality of linear forms on the translucent substrate, a scanning electrode is formed in a plurality of linear forms so as to cross the signal electrode, and a light emitting portion is formed by the cross-points of the signal electrode and scanning electrode being taken as light emitting pixels, and a plurality of the light emitting pixels being disposed. With such an organic EL panel, a line-sequentially scanned image is displayed in the display portion. Such a passive drive organic EL panel has an advantage in that the manufacture is easy in comparison with that of an active drive type.
Patent Document 1: JP-A-59-194393
Patent Document 2: JP-A-2001-217081

EP 1 168 448 A2 describes a full colour flat display panel using an organic EL device, a manufacturing method thereof and a driving circuit of the organic EL device, which includes first, second and third pixels, a plurality of first electrodes, and a plurality of second electrodes perpendicularly intersecting the first electrodes, in which each of the first, second and third light emitting pixels is arranged in each of intersecting positions of the first and second electrodes.

WO 03/007379 A2 describes an organic, electroluminescent, passively matrix-driven display with functional polymer layers contacting a first electrode which are delimited by the windows of an insulating window layer, and at least one further insulating strip-shaped layer. A second electrode contacts the functional layers runs transversely to the first electrode strips.

EP 1 286 397 A2 describes an organic EL display panel including a transparent substrate, a first electrode formed on the transparent substrate, an auxiliary electrode overlapped with the first electrode in part so as to be connected to the first electrode, an organic light-emitting layer formed on the first electrode at the pixel, and a second electrode formed on the organic light-emitting layer so as to cross with the first electrode.

US 2002/033925 A1 describes a reflective liquid crystal display device of a multiple matrix type in which display unevenness is prevented and the image quality is enhanced. A reflective liquid crystal display device of a multiple matrix type of the invention includes a plurality of rows of common electrodes, and a plurality of columns of segment electrodes provided so as to be orthogonal thereto, each segment electrode including a plurality of pixel electrodes arranged in a column, and wiring sections connecting every predetermined number of the pixel electrodes to each other.

EP 0 158 366 A2 describes picture elements of a colour liquid-crystal display. The arrangement patterns of picture-element electrodes are provided which may be driven by a simple driving circuit and may obtain the regenerative images of high quality. In the colour liquid-crystal display apparatus, the delta arrangement is adopted, thus improving the image resolution and the display quality.

US 2004/004214 A1 describes a light emitting device which has light emitting elements formed between a lamination layer and an inorganic compound layer that transmits visual light, where the lamination layer is constructed of one unit or two or more units, and each unit is a laminated structure of a metal layer and an organic compound layer. The lamination layer is formed on the primary surface of the plastic substrate, so that a flexible substrate structure can be obtained while preventing the substrate from deterioration with the transmission of oxygen or moisture content.

JP 2007 115529 A describes a display device with a plurality of pixels PX and sub-pixels composed of a plurality of display elements of different colours in one pixel, and provided with a first sub pixel row RL of a stripe shape on which first display elements 40R are arranged and a second pixel row GL of a stripe shape on which second display elements 40G of a different luminous colour from that of the first display elements are arranged. The first sub pixel row RL and the second sub pixel row GL have effective parts RE and GE having wide widths in a direction crossing a direction of extension of each of the sub pixel rows and connecting parts RC and GC which connect the neighbouring effective parts having narrower widths than the effective parts. In one pixel PX, the effective part RE of the first sub pixel row RL and the connecting part GS of the second pixel row GL are adjacent to each other.

### Disclosure of the Invention

### Problems that the Invention is to Solve

Also, because of the increase and diversification of information, a further increase in size and higher definition of displays has been demanded **in** recent years. However, in increasing the light emitting pixels in the passive drive organic EL panel, in particular, the light emitting drive duty ratio increases along with an increase of the scanning electrodes, the time for which voltage is applied to each line of the scanning electrodes decreases, and current and voltage applied to compensate for this increase proportionately. For this reason, there is a problem in that, due to demand restrictions in a drive IC and product specifications, it is difficult to increase the number of light emitting pixels on the scanning electrode side.

As means of decreasing voltage and current in the passive drive to overcome the described problem, there is disclosed in Patent Document 2 a multiple matrix structure wherein signal electrodes are formed in a pectinate electrode pattern having rectangular pixel electrodes and wiring electrodes connected to the pixel electrodes, pixel portions of differing signal electrodes are alternately combined in nested form at cross portions with the scanning electrode, and the cross portions are configured in such a way that one scanning electrode and at least two signal electrodes (pixel portions) cross.

However, as the multiple matrix structure is formed in such a way that the wiring electrodes are formed between the pixel electrodes, and pixel electrodes connected to differing wiring electrodes are combined in nested form, the pixel electrodes in each column of the pixel electrodes are in a zigzag disposition. For this reason, there is a problem in that, when attempting to dispose the light emitting pixels in a straight line, the aperture ratio (the ratio of the actual area of the light emitting pixels to the area of the pixel electrode) decreases. Also, when attempting to increase the aperture ratio, there is a problem in that the light emitting pixels are in a zigzag disposition in the same way as the pixel electrodes, a zigzag effect occurs in the displayed image, and the display quality decreases.

The invention, bearing in mind the heretofore described problems, has an object of providing an organic EL panel with which it is possible, in a multiple matrix structure, to increase the aperture ratio and maintain a high display quality.

### Means for Solving the Problems

In order to solve the heretofore described problems, the invention provides an organic EL panel as disclosed in claim 1.

Also, the organic EL panel may have the wiring electrodes wired toward one edge of the substrate.

### Advantage of the Invention

The invention relates to an organic EL panel, particularly to a passive drive organic EL panel using organic EL elements having a multiple matrix structure that has a high aperture ratio and can maintain a high display quality in a multiple matrix structure.

### Brief Description of the Drawings

Fig. 1 is an outline view showing the electrode structure of an organic EL panel which is an embodiment of the invention;
Fig. 2 is an enlarged view of the main portion of the organic EL panel;
Fig. 3 is a sectional view of the main portion of the organic EL panel;
Fig. 4 is a diagram showing pixel electrodes of the organic EL panel;
Fig. 5 is an enlarged view of the main portion of an organic EL panel which is a first comparison example;
Fig. 6 is an enlarged view of the main portion of an organic EL panel which is a second comparison example; and
Fig. 7 is a diagram showing other embodiments of the invention.

### Description of Reference Numerals and Signs

- 1: Signal electrode
- 1a: Pixel electrode
- 1b: Wiring electrode
- 1c: Cutaway portion
- 2: Scanning electrode
- 2a: Rib
- 3: Auxiliary electrode
- 4: Insulation layer
- 4a: Aperture portion
- 5: Functional organic layer
- 6: Glass substrate
- 7: Signal electrode side drive circuit
- 8: Scanning electrode side drive circuit

### Best Mode for Carrying Out the Invention

Hereafter, a description will be given, based on the attached drawings, of an organic EL panel, which is an embodiment of the invention.

The organic EL panel of the embodiment includes, as its basic configuration, an organic EL element formed by stacking functional organic layers having at least a light emitting layer between a signal electrode and a scanning electrode that are disposed to face each other so as to cross each other on a translucent glass substrate.

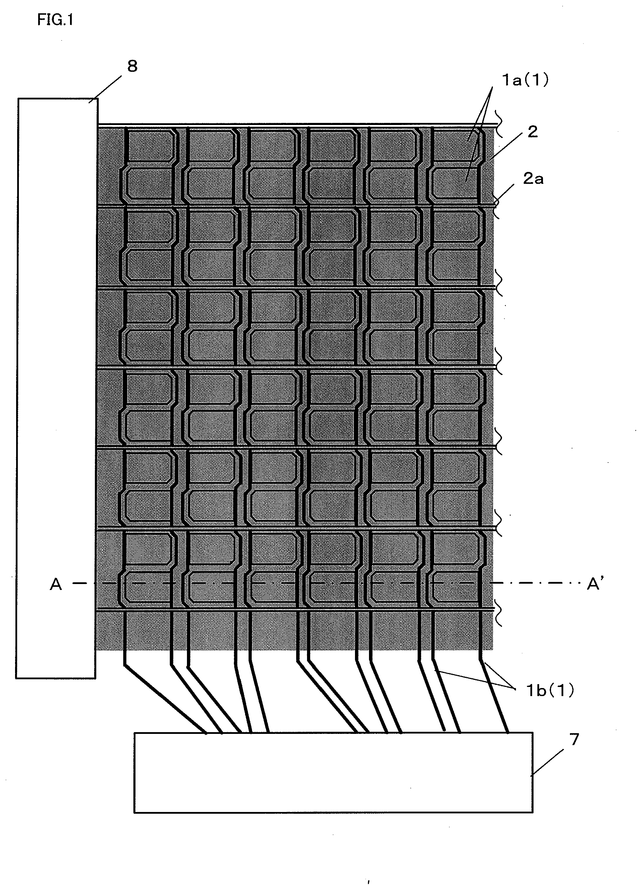

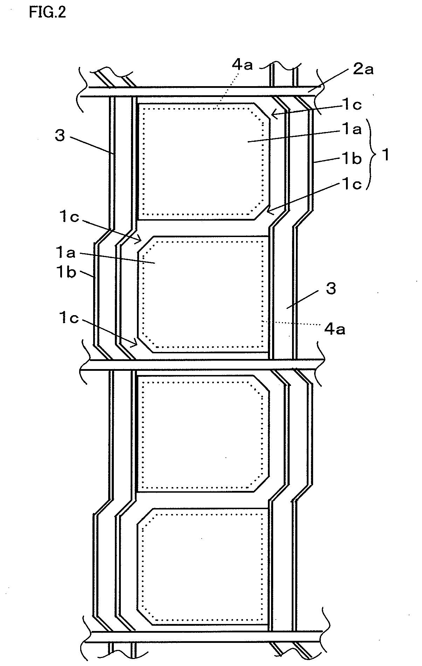

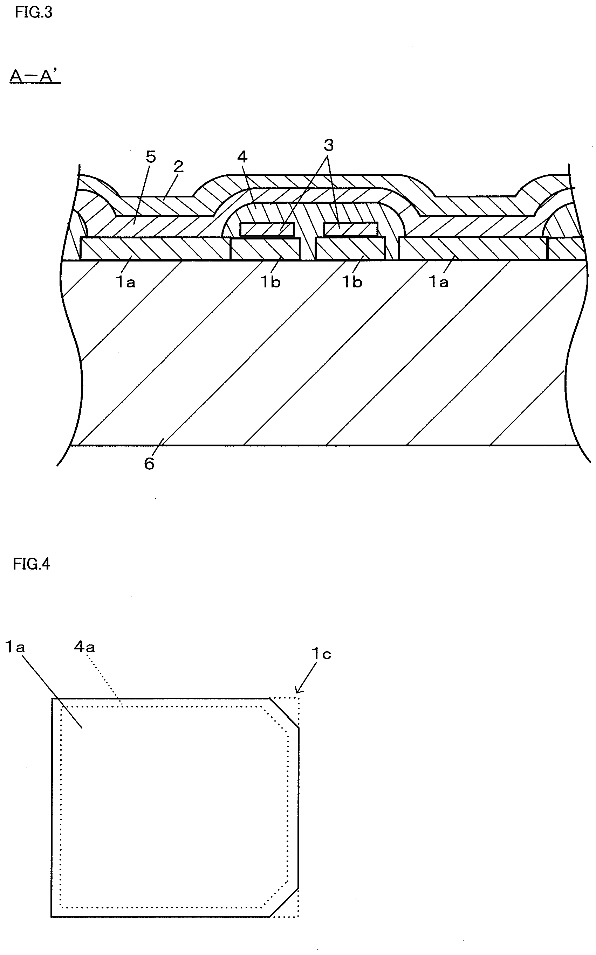

Figs. 1 and 2 show an electrode structure of the organic EL panel. The organic EL panel includes a signal electrode 1, which has pixel electrodes 1a and wiring electrodes 1b and configures an anode, a scanning electrode 2, which is formed so as to cross the signal electrode 1 and configures a cathode, and auxiliary electrodes (3)formed on the wiring electrodes (1b). In the organic EL panel, the places where the pixel electrodes 1a and scanning electrode 2 face (cross) are used as light emitting pixels (the organic EL elements), a light emitting portion is formed by disposing a plurality of the light emitting pixels in a matrix. An insulation layer is formed below the scanning electrode 2, excepting the portions configuring the light emitting pixels, to prevent a short circuiting of the signal electrode 1 and scanning electrode 2. In Fig. 3 a sectional view of the main portion of the organic EL panel, 4 is the short circuit preventing insulation layer, 5 is the organic layers including at least a light emitting layer, and 6 is a glass substrate.

The signal electrode 1 has a plurality of the pixel electrodes 1a disposed in a matrix form, and the wiring electrodes 1b connected to the pixel electrodes 1a. The signal electrode 1 is formed in such a way that, with a plurality (two in the embodiment) of pixel electrodes 1a adjacent to one another column-wise (in a direction perpendicular to the scanning electrode) as one unit, each of the pixel electrodes 1a in one unit is connected to a different wiring electrode 1b. That is, two lines of the signal electrode 1 so configure one column of the light emitting pixels.

The pixel electrodes 1a are formed by a translucent conductive material such as ITO (indium tin oxide) being formed in layer form on the glass substrate by a sputtering method or the like, and patterned into a predetermined shape by, for example, a photolithography method. Also, the pixel electrodes 1a are formed in a substantially rectangular shape and each have a cutaway portion 1c in an end portion. Fig. 4 shows only the pixel electrode 1a. The cutaway portion 1c is a portion of the end of the pixel electrode 1a which is obliquely removed. As the shape of the light emitting pixel to be shown through an aperture portion 4a of the insulation layer 4 is also partly missing in accordance with the cutaway portion 1c, it is preferable that the cutaway portion 1c is of a size that is not viewable to a user. For example, it is preferable that the vertical and horizontal lengths of the cutaway portion 1c are 0.2mm or less, or 1/3 or less of the length of the pixel electrode 1a. Also, in the event that the organic EL panel is used in a portable instrument which is seen from a close distance, it is more preferable that the vertical and horizontal lengths are 0.07mm or less. Also, practically, it has been confirmed that a cutaway of 0.003mm or more is necessary.

The wiring electrodes 1b are made of, for example, the same material as that of the pixel electrodes 1a and are formed together with the pixel electrodes 1a. The wiring electrodes 1b are wired between the respective columns of the pixel electrodes 1a so as to cross the scanning electrode 2, and are connected alternately to each pixel electrode 1a in each column of the pixel electrodes 1a. Also, the wiring electrodes 1b are formed so as to partially curve or bend in order to avoid the pixel electrodes 1a connected to another wiring electrode 1b in each column of the pixel electrodes 1a. Then, the curved places or bent places of the wiring electrodes 1b are formed along the cutaway portions 1c of the pixel electrodes 1a. Also, the wiring electrodes 1b, each being wired toward one side of the glass substrate, are connected to a signal electrode side drive circuit 7. The signal electrode side drive circuit 7 supplies power to the signal electrode 1 in order to display a predetermined image in accordance with sequential scans of the scanning electrode 2 by a scanning electrode side drive circuit 8 to be described hereafter.

The scanning electrode 2 is formed by forming a layer of a metallic conductive material with a conductivity higher than that of the signal electrode 1, such as aluminum (Al), magnesium (Mg), cobalt (Co), lithium (Li), gold (Au), zinc (Zn), or an alloy thereof, using a deposition method or the like, and separating the layer into a plurality of linear forms by ribs 2a configured of an insulating resin material formed in linear form. Each scanning electrode 2 is formed so as to cross the signal electrode 1, and to face one unit of the pixel electrodes 1a in the columnar direction. For this reason, although the insulation layer 4 is formed between the pixel electrodes 1a in one unit, the ribs 2a for separating the scanning electrode 2 are not formed in the upper portion thereof. Also, each scanning electrode 2 is connected to the scanning electrode side drive circuit 8. The scanning electrode side drive circuit 8 sequentially scans the scanning electrodes 2 at a predetermined duty ratio.

The auxiliary electrodes 3 are formed by a material of an electrical resistance lower than that of the material configuring the pixel electrodes 1a, such as chrome (Cr), being formed in a layer form on the glass substrate by a sputtering method or the like, and patterned into a predetermined shape by, for example, a photolithography method. The auxiliary electrodes 3 formed on the respective wiring electrodes 1b, so as to partially curve or bend along the cutaway portions 1c of the pixel electrodes 1a, in the same way as the shape of the wiring electrodes 1b. The auxiliary electrodes 3 may be segmentalized into a plurality, portions excepting the connecting places of the wiring electrodes 1b and the pixel electrodes 1a.

Such organic EL panel is of a so-called multiple matrix structure, and two lines of light emitting pixels are illumination controlled when scanning of one line of the scanning electrode 2 is carried out.

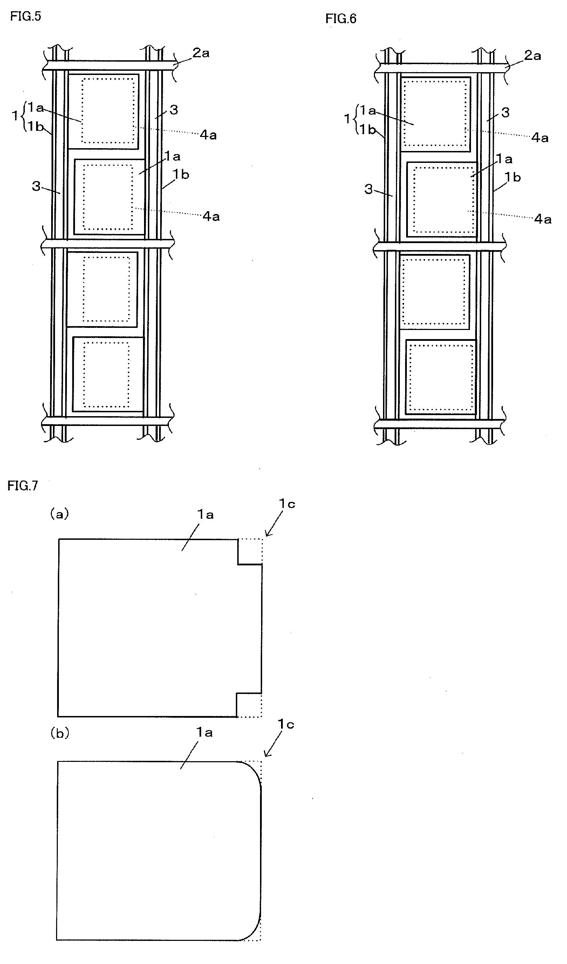

In the organic EL panel of the embodiment, it is possible, by forming the wiring electrodes 1b so as to partially curve or bend along the pixel electrodes 1a connected to another wiring electrode 1b, to dispose the pixel electrodes 1a overlapping linearly, rather than in the heretofore known zigzag disposition. Figs. 5 and 6 show first and second comparison examples of the heretofore known pixel electrodes 1a in a zigzag disposition. In the first comparison example of Fig. 5, since the light emitting pixels shown through the aperture portions 4a of the insulation layer 4 are disposed in a straight line, the peripheral portions of the pixel electrodes 1a, which do not overlap each other, cannot be used as light emitting pixels and thus the aperture ratio is reduced. Also, in the second comparison example of Fig. 6, as a result of increasing the aperture ratio, the light emitting pixels are in a zigzag disposition corresponding to the positional misalignment of the pixel electrodes 1a, and a zigzag effect occurs in the displayed image. As opposed to this, in the embodiment, as the pixel electrodes 1a are disposed in a straight line so as to overlap each other in each column, it is possible to dispose the light emitting pixels in a straight line even in increasing the aperture ratio, including the peripheral portions of the pixel electrodes 1a, and it is possible to maintain a high display quality. In particular, by providing the cutaway portions 1c in the end portion of the pixel electrodes 1a, and forming the wiring electrodes 1b so as to curve or bend along the cutaway portions 1c, there is no need to leave an unnecessary interval between the pixel electrodes 1a, and it is possible to maintain a high display quality.

In the embodiment, the cutaway portion 1c is formed by removing the end portion of the pixel electrode 1a in a substantially triangular shape, but the shape of the cutaway portions 1c is not limited to this, and the shapes as shown in Fig. 7 may also be adopted. In Fig. 7(a), the cutaway portions 1c are of a rectangular shape, and in Fig. 7(b), the cutaway portions 1c are provided by removing the end portion of the pixel electrodes 1a in an arc shape. In the embodiment, the cutaway portions 1c are provided in only one portion of the end portions, but they may of course be provided in all the end portions.

Also, in the embodiment, one unit is configured of two pixel electrodes 1a, and each pixel electrode 1a in one unit is connected to a different wiring electrode 1b, but the invention may also be applied to the case of one unit configured of three or more pixel electrodes 1a.

### Industrial Applicability

The invention relates to an organic EL panel using organic EL elements, and is particularly preferable in a passive drive organic EL panel having a multiple matrix structure.

## Claims

1. An organic EL panel including:
organic EL elements formed by stacking organic layers having at least an organic light emitting layer (5) between a signal electrode (1) and a scanning electrode (2) that are disposed facing each other so as to cross each other on a substrate (6), wherein
the signal electrode (1) comprises a plurality of pixel electrodes (1a) formed in a substantially rectangular shape and disposed in a matrix, and a plurality of wiring electrodes (1b) connected alternately to each pixel electrode of the plurality of pixel electrodes (1a) in each column of the matrix,
wherein the wiring electrodes (1b) are formed between columns of the pixel electrodes (1a) and are formed in such a way as to partially curve or bend along the pixel electrodes (1a) connected to another wiring electrode (1b), in order to avoid the pixel electrodes (1a) connected to another wiring electrode (1b) in each column of the pixel electrodes (1a), and
**characterized in that** each of the plurality of pixel electrodes (1a) have at least one cutaway portion (1c), the at least one cutaway portion being a portion of the end of the pixel electrode that is obliquely removed, and
the wiring electrodes (1b) are formed so as to partially curve or bend along the cutaway portion (1c), and
further including auxiliary electrodes (3) which are formed on the wiring electrodes (1b) and made of a material of an electrical resistance lower than that of the wiring electrodes (1b), wherein the auxiliary electrodes (3) are formed on the respective wiring electrodes (1b) so as to partially curve or bend along the cutaway portions (1c) of the pixel electrodes (1a), in the same way as the shape of the wiring electrodes (1b).

2. The organic EL panel according to claim 1, **characterized in that** the wiring electrodes (1b) are wired toward one edge of the substrate (6).

## Patentansprüche

1. Organisches EL-Panel, das Folgendes beinhaltet:
organische EL-Elemente, die durch das Stapeln organischer Schichten gebildet werden, die mindestens eine organische lichtemittierende Schicht (5) zwischen einer Signalelektrode (1) und einer Abtastelektrode (2) aufweisen, die einander zugewandt angeordnet sind, sodass sie sich auf einem Substrat (6) überkreuzen, wobei
die Signalelektrode (1) mehrere Pixelelektroden (1a), die in einer im Wesentlichen rechteckigen Form ausgebildet und in einer Matrix angeordnet sind, und mehrere Verdrahtungselektroden (1b), die abwechseln mit jeder Pixelelektrode der mehreren Pixelelektroden (1a) in jeder Spalte der Matrix verbunden sind, umfasst,
wobei die Verdrahtungselektroden (1b) zwischen Spalten der Pixelelektroden (1a) ausgebildet sind und auf eine derartige Weise gebildet werden, dass sie sich entlang der Pixelelektroden (1a), die mit einer anderen Verdrahtungselektrode (1b) verbunden sind, teilweise krümmen oder biegen, um die Pixelelektroden (1a), die mit einer anderen Verdrahtungselektrode (1b) verbunden sind, in jeder Spalte der Pixelelektroden (1a) zu vermeiden, und
**dadurch gekennzeichnet, dass** jede der mehreren Pixelelektroden (1a) mindestens einen weggeschnittenen Teil (1c) aufweist, wobei der mindestens eine weggeschnittene Teil ein Teil des Endes der Pixelelektrode ist, der schräg entfernt wird, und
die Verdrahtungselektroden (1b) so ausgebildet sind, dass sie sich entlang des weggeschnittenen Teils (1c) teilweise krümmen oder biegen, und
ferner Folgendes beinhaltend: Hilfselektroden (3), die auf den Verdrahtungselektroden (1b) ausgebildet und aus einem Material mit einem elektrischen Widerstand geringer als der der Verdrahtungselektroden (1b) hergestellt sind, wobei die Hilfselektroden (3) so auf den jeweiligen Verdrahtungselektroden (1b) ausgebildet sind, dass sie sich entlang der weggeschnittenen Teile (1c) der Pixelelektroden (1a) auf dieselbe Weise wie die Form der Verdrahtungselektroden (1b) teilweise krümmen oder biegen.

2. Organisches EL-Panel nach Anspruch 1, **dadurch gekennzeichnet, dass** die Verdrahtungselektroden (1b) zu einem Rand des Substrats (6) verdrahtet sind.

## Revendications

1. Panneau EL organique, comprenant :
des éléments EL organiques formés par un empilement de couches organiques comportant au moins une couche émettrice de lumière organique (5) entre une électrode de signal (1) et une électrode de balayage (2) qui sont disposées en se faisant face de façon à se croiser sur un substrat (6), dans lequel
l'électrode de signal (1) comprend une pluralité d'électrodes de pixel (1a) formées selon une forme substantiellement rectangulaire et disposées dans une matrice, et une pluralité d'électrodes de câblage (1b) connectées en alternance à chaque électrode de pixel de la pluralité d'électrodes de pixel (1a) dans chaque colonne de la matrice,
dans lequel les électrodes de câblage (1b) sont formées entre des colonnes des électrodes de pixel (1a) et sont formées de façon à s'incurver ou se courber partiellement le long des électrodes de pixel (1a) connectées à une autre électrode de câblage (1b), afin d'éviter les électrodes de pixel (1a) connectées à une autre électrode de câblage (1b) dans chaque colonne des électrodes de pixel (1a), et
**caractérisé en ce que** chacune de la pluralité d'électrodes de pixel (1a) présente au moins une partie découpée (1c), ladite au moins une partie découpée étant une partie de l'extrémité de l'électrode de pixel qui est retirée en oblique, et
les électrodes de câblage (1b) sont formées de façon à s'incurver ou se courber partiellement le long de la partie découpée (1c), et
comprenant en outre des électrodes auxiliaires (3) qui sont formées sur les électrodes de câblage (1b) et réalisées à partir d'un matériau d'une résistance électrique inférieure à celle des électrodes de câblage (1b), dans lequel les électrodes auxiliaires (3) sont formées sur les électrodes de câblage respectives (1b) de façon à s'incurver ou se courber partiellement le long des parties découpées (1c) des électrodes de pixel (1a) comme la forme des électrodes de câblage (1b).

2. Panneau EL organique selon la revendication 1, **caractérisé en ce que** les électrodes de câblage (1b) sont câblées en direction d'un bord du substrat (6).
